# EUROPÄISCHE PATENTSCHRIFT

(11) **EP 1 769 543 B1**
(45) Veröffentlichungstag und Bekanntmachung des Hinweises auf die Patenterteilung: **22.01.2014**
(21) Anmeldenummer: 05804921.4
(22) Anmeldetag: 22.02.2005
(51) Int. Cl.: H01L 41/20, F16F 15/00, H01L 41/12

(54) **MAGNETOSTRIKTIVES ELEMENT UND DESSEN VERWENDUNG**
MAGNETOSTRICTIVE ELEMENT AND USE THEREOF
ELEMENT MAGNETOSTRICTIF ET SON UTILISATION

(30) Priorität: 17.07.2004 DE 102004034723
(43) Veröffentlichungstag der Anmeldung: 04.04.2007
(73) Patentinhaber: Carl Freudenberg KG, 69469 Weinheim (DE)
(72) Erfinder: HEINRICH, Ralf, 67365 Schwegenheim (DE); RYZKO, Peter, 69514 Laudenbach (DE)
(86) Internationale Anmeldenummer: PCT/EP2005/001794
(87) Internationale Veröffentlichungsnummer: WO 2006/007882

(56) Entgegenhaltungen:
- WO-A-92/20829
- WO-A-03/075290
- US-A1- 2003 168 295
- BEDNAREK S: "The giant magnetostriction in ferromagnetic composites within an elastomer matrix" APPLIED PHYSICS A (MATERIALS SCIENCE PROCESSING) SPRINGER-VERLAG GERMANY, Bd. 68, Nr. 1, Januar 1999 (1999-01), Seiten 63-67, XP002330081 ISSN: 0947-8396
- PULLIAM W, MCNIGHT G AND CARMAN G: "Recent Advances in Magnetostrictive Particulate Composite Technology" SMART STRUCTURES AND MATERIALS 2002. INDUSTRIAL AND COMMERCIAL APPLICATIONS OF SMART STRUCTURES TECHNOLOGIES 18-21 MARCH 2002 SAN DIEGO, CA, USA, Bd. 4698, 2002, Seiten 271-281, XP002330082 Proceedings of the SPIE - The International Society for Optical Engineering SPIE-Int. Soc. Opt. Eng USA ISSN: 0277-786X
- GINDER J M ET AL: "Magnetostrictive phenomena in magnetorheological elastomers" INTERNATIONAL JOURNAL OF MODERN PHYSICS B WORLD SCIENTIFIC SINGAPORE, Bd. 16, Nr. 17-18, 20. Juli 2002 (2002-07-20), Seiten 2412-2418, XP009048165 ISSN: 0217-9792
- BELLAN C ET AL: "Field dependence of viscoelastic properties of MR elastomers" INTERNATIONAL JOURNAL OF MODERN PHYSICS B WORLD SCIENTIFIC SINGAPORE, Bd. 16, Nr. 17-18, 20. Juli 2002 (2002-07-20), Seiten 2447-2453, XP009048159 ISSN: 0217-9792
- FARSHAD M AND BENINE A: "Magnetoactive elastomer polymers" POLYMER TESTING, Bd. 23, Nr. 3, Mai 2004 (2004-05), Seiten 347-353, XP002330083

## Beschreibung

Magnetostriktive Materialien sind an sich bekannt. Darunter versteht man Materialien, deren Dimensionen sich in Gegenwart eines magnetischen Feldes ändern oder die bei Änderungen ihrer Dimensionen magnetische Felder erzeugen.

Der magnetostriktive Effekt entspricht dem piezoelektrischen Effekt, welcher Dimensionsänderungen des Materials durch Anwesenheit eines elektrischen Feldes zur Folge hat. Beim piezoelektrischen Effekt müssen in der Regel sehr hohe elektrische Feldstärken bzw. sehr hohe Spannungen im Bereich von einigen Kilovolt eingesetzt werden, um nennenswerte Dimensionsänderungen zu erreichen. Im Gegensatz dazu sind magnetostriktive Materialien bekannt, bei denen vergleichs-weise geringe Spannungen eingesetzt werden müssen, um die gewünschten Dimensionsänderungen zu erzielen. Ein solches Material ist unter der Bezeichung Terfenol-D bekannt; dabei handelt es sich um eine Legierung aus Eisen, Terbium und Dysprosium.

Magnetostriktive Materialien sind beispielsweise in den Dokumenten EP-A-361,969, WO-A-00/33,324, US-A-6,273,965 und US-A-5,223,046 beschrieben.

Es sind auch bereits magnetostriktive Elastomermaterialien bekannt (vergl. Midé Technology Corporation, Magnetostrictive Elastomers, www.mide.com). Einzelheiten über deren Aufbau sind dem Dokument nicht zu entnehmen.

Ferner sind Elastomerschäume bekannt, die magnetische Teilchen enthalten.

JP-A-2002/278,425 offenbart ein geschäumtes Polymermaterial, das magnetische Pulver enthält. Dieses wird zur Abdichtung von Fotokopiergeräten eingesetzt, um den Austritt von Toner zu verhindern. Mögliche Polymere sind Elastomere, wie Ethylen-Propylen-Elastomere.

JP-A-03/122,139 offenbart magnetisierte Kautschukmassen zur Herstellung von vernetzten Schäumen. Diese werden zur Schallisolierung sowie zur Schwingungsdämpfung eingesetzt.

JP-A-58/533,928 offenbart flexible, zelluläre Elastomere enthaltend Metallpulver. Diese werden zur Abschirmung von Strahlung eingesetzt.

Keines dieser Dokumente offenbart den Einsatz von Elastomerschäumen unter Ausnutzung des magnetostriktiven Effekts, beispielsweise deren Einsatz als Aktuatoren, adaptive Dämpfer oder als Sensoren für Dimensionsänderungen von Materialien.

Elastomerschäume enthaltend ein magnetostriktives Material gehen unter anderem aus S. Bednarek, Appl. Phys. A 68 (1999) 63-67, W. Pullium et al. Proc. SPIE 4698 (2002) 271-281 sowie J. M. Ginder et al. Int. J. Mod. Phys. 16 (2002) 2447-2453 hervor.

Es wurde jetzt gefunden, daß poröse Polymere enthaltend ferromagnetische Teilchen einen im Vergleich zu den entsprechenden kompakten Polymermaterialien deutlich verstärkten magnetostriktiven Effekt aufweisen.

Aufgabe der vorliegenden Erfindung ist die Bereitstellung von gefüllten porösen Polymeren, die einen ausgeprägten magnetostriktiven Effekt aufweisen.

Eine weitere Aufgabe bestand in der Bereitstellung eines Verfahrens zum gezielten Bewegen von Gegenständen oder zur Schwingungsdämpfung von Gegenständen oder zum Feststellen der Dimensionsänderungen von Gegenständen, das sich durch eine hohe Sensitivität auszeichnet, das einfach durchzuführen ist und das reproduzierbare Ergebnisse liefert.

Die vorliegende Erfindung betrifft ein magnetostriktives Element umfassend
a) mindestens eine Vorrichtung zur Erzeugung eines magnetischen Feldes und,
b) mindestens ein porösas Formteil aus porösem Polymer enthaltend ferromagnetische Teilchen.

Die erfindungsgemäß eingesetzte Vorrichtung kann beliebiger Natur sein, solange damit ein magnetisches Feld erzeugt werden kann. Typischerweise handelt es sich dabei um einen elektrischen Leiter, vorzugsweise einen metallischen Leiter, der sich in der Nähe des Formteils befindet, so daß das durch die Vorrichtung erzeugte Magnetfeld auf das Formteil einwirken kann oder umgekehrt, daß ein durch Formteil erzeugtes Magnetfeld auf die Vorrichtung einwirken kann.

Bei dem Magnetfeld kann es sich um ein konstantes Magnetfeld handeln oder vorzugsweise um ein zeitlich sich änderndes Magnetfeld.

Vorzugsweise ist die Vorrichtung in Form einer Spule ausgestaltet, die sich In der Nähe des Formteils befindet, besonders bevorzugt um das Formteil, das insbesondere die Form eines Zylinders aufweist, gewickelt ist.

Das Formteil kann beliebige Gestalt aufweisen und dem jeweiligen Anwendungszweck angepaßt sein.

Bevorzugt weist das Formteil die Form eines Zylinders auf.

Zur Herstellung von porösen Formkörpern aus porösen Polymeren können grundsätzlich alle Polymere eingesetzt werden. Dabei handelt es sich typischerweise um thermoplastische oder um vernetzte bzw, teilvernetzte Polymere einschließlich der Elastomeren.

Diese Formkörper enthalten mit Gas gefüllte Poren. Die Größe der Poren kann in weiten Bereichen achwanken. Typische Porengrößen bewegen sich im Bereich von 10 µm bis 3 mm. Die Poren können beliebige Gestalt aufweisen. Die Formkörper können geschlossene Poren und/oder offene Poren aufweisen. Das Porenvolumen des Formkörpers beträgt typischerweise mindestens 5 Volumen %.

Besonders bevorzugt werden Formkörper aus Elastomerschäumen einschließlich der Schäume aus thermoplastischen Elastomeren eingesetzt.

Die erfindungsgemäß eingesetzten Formkörper aus porösen Polymeren sind unter dem Einfluss von Druck in Ihrem Volumen veränderbar im Gegensatz zu Formkörpern aus kompakten Polymeren.

Die erfindungsgemäß eingesetzten porösen Polymere können sich von beliebigen Thermoplasten ableiten. Beispiele für Thermoplaste sind synthetische Polymere, wie thermoplastische Polyurethane, Polysulfone, Polyether, Polyketone und Polyetherketone, Polyamide, Polyester, Poly-(arylenoxide), Poly-(arylensulfide), Polyetherimide, Polyacetale, Vinyl-Polymere, Polyacrylate und Polyolefine.

Besonders bevorzugt werden Elastomerschäume eingesetzt. Darunter sind im Rahmen dieser Beschreibung geschäumte Kunststoffe zu verstehen, die gummielastisches Verhalten aufweisen. Dabei handelt es sich also um weitmaschig chemisch oder physikalisch vernetzte Polymere, die sich unter ihrem Glaspunkt stahlelastisch verhalten und die bei Temperaturen oberhalb ihres Glaspunktes gummielastisch sind, die also auch bei hohen Temperaturen nicht viskos fließen. Glastemperaturen von bevorzugt eingesetzten Elastomeren liegen bei 20°C und darunter. Bevorzugt verhalten sich die erfindungsgemäß eingesetzten Elastomerschäume bis zu ihrer Schmelz- oder Zersetzungstemperatur gummielastisch.

Typische und gleichzeitig bevorzugt eingesetze Kautschuke sind Acrylat-Kautschuk, Polyester-Urethan-Kautschuk, bromierter Butyl-Kautschuk, Polybutadien, chlorierter Butyl-Kautschuk, chloriertes Polyethylen, Epichlorhydrin-Homopolymer, Polychloropren, sulfuriertes Polyethylen, Ethylen-Acrylat-Kautschuk, Ethylen-Vinylactetat-Kautschuk, Epichlorhydrin-Copolymere, Ethylen-Propylen-Copolymere (EP(D)M), schwefelvernetzt oder peroxidvemetzt, Polyether-Urethan-Kautschuk, Ethylen-Vinylacetat-Copolymer, Fluor-Kautschuk, Silikonkautschuke, wie Fluorsilikon-Kautschuk (FVMQ) oder vinylhaltiges Dimethylpolysiloxan, sowie hydrierter Nitril-Kautschuk, Butyl-Kautschuk, Halobutyl-Kautschuk, Polyoctenamer, Polypentenamer, NitrilKautschuk, Naturkautschuk, Thioplaste, Polyfluorphosphazene, Polynorbornen, Styrol-Butadien-Kautschuk, carboxygruppenhaltiger Nitril-Kautschuk oder Gemische aus einem oder mehreren dieser Kautschuke.

Weitere bevorzugt eingesetzte Ausgangsstoffe zur Herstellung der erfindungsgemäß eingesetzten porösen Polymere sind thermoplastische Elastomere, wie thermoplastische Polyester (TPE-E), thermoplastische Polyamide (TPE-A), unvernetzte thermoplastische Polyolefine (TPE-O), teilvemetzte thermoplastische Polyolefine (TPE-V), thermoplastische Styrolpolymere (TPE-S) und insbesondere thermoplastische Polyurethane (TPE-U).

Die porösen Polymere können beliebige Zelltypen und Zellgrößen aufweisen. Es können offenzellige oder geschlossenzellige Schäume eingesetzt werden, also Schäume, bei denen zumindest ein Teil der einzelnen Poren miteinander in Kontakt steht oder bei denen alle Poren voneinander isoliert in der Polymermatrix vorliegen. Typische Porengrößen bewegen sich im Bereich von 10 µm bis 3 mm.

Die erfindungsgemäß eingesetzten porösen Polymere können durch chemische und/oder physikalische Schaumbildungsverfahren in an sich bekannter Weise hergestellt werden.

Zur Herstellung der Formkörper aus porösen Polymeren können Polymere, insbesondere Kautschuke oder thermoplastische Elastomere in unterschiedlichen Ausprägungen eingesetzt werden, beispielsweise als Granulat oder in anderer zerkleinerter Form. Diese werden üblicherweise zusammen mit Treibmitteln, ferromagnetischen Materialien und gegebenenfalls weiteren Zusatzstoffen, wie Vernetzern, Vernetzungshilfsmitteln sowie anderen an sich üblichen Zusätzen, wie Weichmachern, Füllstoffen, Formtrennmitteln und/oder Pigmenten, miteinander vermischt und durch Erhitzen aufgeschäumt.

Die Verarbeitung kann in beliebigen Aggregaten erfolgen. Beispiele dafür sind Kneter, Walzwerke oder Extruder. Die Verarbeitung kann trocken oder naß erfolgen.

Das Aufschäumen kann bereits in den Mischaggregaten erfolgen oder in einem nachgeschalteten Schritt, beispielsweise durch Erhitzen eines Walzfelles in einer beheizbaren Presse unter gleichzeitigem Reduzieren des Pressdruckes oder in einer Spritzgussvorrichtung.

Elastomerschäume werden üblicherweise unter Verwendung von Vemetzungsmitteln verarbeitet. Dafür können alle gängigen Typen eingesetzt werden.

Typische und gleichzeitig bevorzugte Vernetzungsmittel sind Schwefel, Fettsäuren, wie Laurinsäure oder Stearinsäure, vernetzende Harze, wie Polymethylolphenolharze, oder Verbindungen, die auch als Vernetzungsbeschleuniger wirken. Dazu zählen beispielsweise Thiurame, Guanidine, Thiazole, Xanthogenate, Dithiocarbamate, Thiazysulfenamide, Dithiophosphate, Peroxide, Bisphenol-Triazinbeschleuniger oder Chinondioxime.

Als Vernetzungshilfsmittel können alle gängigen Typen eingesetzt werden. Bevorzugt werden Metalloxide, insbesondere Magnesium- oder Zinkoxid.

Als ferromagnetische Materialien können alle Materialien verwendet werden, die einen ferromagnetischen Effekt besitzen. Vorzugsweise handelt es sich dabei um ferromagnetische Materialien, die außerdem noch einen magnetostriktiven Effekt aufweisen, bei denen sich also unter Einfluss eines Magnetfeldes mindestens eine Dimension verändert.

Die erfindungsgemäß eingesetzten ferromagnetischen Materialien können vom hartmagnetischen oder vorzugsweise vom weichmagnetischen Typ sein, also nach dem Abschalten des Magnetfeldes zumindest eine Restmagnetisierung behalten oder vorzugsweise die Magnetisierung verlieren.

Die ferromagnetischen Materialien werden in feinteiliger Form dem porösen Polymer zugesetzt. Der Anteil der ferromagnetischen Teilchen im Formkörper beträgt typischerweise 10 bis 70 Vol. %, bezogen auf das Volumen des Formkörpers. Die Teilchen können beliebige Gestalt aufweisen, beispielsweise rund, ellipsoid, irregulär oder in Form von Fasern. Der mittlere Durchmesser dieser Teilchen (D₅₀ Wert) kann in weiten Bereichen schwanken. Typische Teilchendurchmesser bewegen sich im Bereich von 0,1 µm bis 1 mm, bevorzugt im Bereich von 10 bis 300 µm.

Neben dem Einsatz korpuskularer oder faserförmiger Teilchen können auch Konglomerate solcher Teilchen Verwendung finden. Die Konglomerate können unterschiedliche Gestalt annehmen. Dabei kann es sich um netzartige Strukturen, z.B. um Perkolationsnetzwerke aus Fasern handeln.

Bevorzugt eingesetzte ferromagnetische Materialien enthalten Cobalt und/oder Nickel und/oder insbesondere Eisen.

Besonders bevorzugt wird Cobalt-, Nickel- oder insbesondere Eisenpulver verwendet.

Bei den ebenfalls bevorzugt eingesetzten ferromagnetischen und magnetostriktiven Materialien handelt es sich beispielsweise um Metallgemische oder Metall-legierungen, die aus den EP-A-361,969, WO-A-00/33,324, US-A-6,273,965 und US-A-5,223,046 bekannt sind.

Bevorzugt eingesetzte ferromagnetische Materialien enthalten Eisen und/oder Cobalt und/oder Nickel sowie Mangan, Kupfer, Seltenerdmetalle oder Kombinationen von einem oder mehreren dieser Metalle.

Besonders bevorzugt eingesetzte magnetostriktive Materialien sind ferromagnetische Legierungen und enthalten Eisen und Seltenerdmetalle, insbesondere ferromagnetische Legierungen, die Terbium, Dysprosium und Eisen enthalten.

Die Erfindung betrifft auch die Verwendung des erfindungsgemäßen magnetostriktiven Elements zum Dämpfen von Schwingungen eines Gegenstandes durch die Maßnahmen:
i) Ermitteln des Schwingungsspektrums des Gegenstandes durch mindestens einen Sensor,
ii) Erzeugen eines zeitlich sich ändernden magnetischen Feldes, dessen zeitlicher Verlauf geeignet ist zumindest einen Teil des Schwingungs-spektrums des Gegenstandes durch Interferenz zu kompensieren,
iii) Einwirken des magnetischen Feldes auf mindestens ein oben definiertes Formteil und Erzeugen einer zeitlichen Änderung der Dimensionen dieses Formteils, und
iv) Einwirken des Formteils auf den Gegenstand, so daß dadurch dessen Schwingungen wenigstens teilweise kompensiert werden.

Neben diesem Verfahren zur aktiven Schwingungsdämpfung betrifft die Erfindung auch ein Verfahren zur passiven Schwingungsdämpfung.

Dabei handelt es sich um eine Verwendung des erfindungsgemäßen magnetostriktiven Elements zum Dämpfen von Schwingungen eines Gegenstandes durch die Maßnahmen:
v) Erzeugen eines magnetischen Feldes vorbestimmter Größe in einer oben definierten Vorrichtung, das
vi) auf mindestens ein oben definiertes Formteil einwirkt und dadurch die Dämpfungseigenschaften dieses Formteils in vorbestimmter Weise beeinflusst.

Eine weitere erfindungsgemäße Verwendung des erfindungsgemäßen magnetostriktiven Elements betrifft die Ermittlung der Änderung der Dimensionen eines Gegenstandes durch die Maßnahmen:
vii) Einwirken des Gegenstands auf ein oben definiertes Formteil, so daß sich bei Änderungen der Dimension des Gegenstands mindestens eine Dimension des Formteils verändert, und
viii) Ermitteln der Stärke des durch die Dimensionsänderung des Formteils erzeugten Magnetfeldes durch Induktion eines elektrischen Stroms in einem elektrischen Leiter, der sich in der Nähe des Formteils befindet.

Noch eine weitere erfindungsgemäße Verwendung des erfindungsgemäßen magnetostriktiven Elements betrifft die gezielten Veränderung der Position eines Gegenstandes durch die Maßnahmen:
ix) Erzeugen eines magnetischen Feldes vorbestimmter Größe in einer der oben definierten Vorrichtung, das
x) auf mindestens ein oben definiertes Formteil einwirkt und dadurch die Dimensionen des Formteils in vorbestimmter Weise beeinflußt, und
xi) Einwirken des Formteils auf den Gegenstand, so daß dieser dadurch in vorbestimmter Weise bewegt wird.

Die Erfindung betrifft auch die Verwendung eines porösen Formteils aus porösen Polymeren enthaltend ferromagnetische Teilchen als Aktuator, als Dämpfungselement für Schwingungen, sowie als Sensor für mechanische Änderungen von Gegenständen, insbesondere als Schwingungssensor.

## Patentansprüche

1. Magnetostriktives Element umfassend
a) mindestens eine Vorrichtung zur Erzeugung eines magnetischen Feldes und,
b) mindestens ein Formteil aus porösem Polymer enthaltend ferromagnetische Teilchen und mit Gas gefültte Poren.

2. Magnetostriktives Element nach Anspruch 1, **dadurch gekennzeichnet, daß** das Formteil aus porösem Polymer in Form eines Zylinders ausgestaltet ist, um das die Vorrichtung zur Erzeugung eines magnetischen Feldes in Form einer Spule aus elektrisch leitfähigem Material gewickelt ist.

3. Magnetostriktives Element nach Anspruch 1, **dadurch gekennzeichnet, daß** das poröse Polymere ein Elastomerschaum ist.

4. Megnetostriktives Element nach Anspruch 3, **dadurch gekennzeichnet, daß** der Elastomerschaum sich ableitet von Acrylat-Kautschuk, Polyester-Urethan-Kautschuk, bromiertem Butyl-Kautschuk, Polybutadien, chloriertem Butyl-Kautschuk, chloriertem Polyethylen, Epichlorhydrin-Homopolymer, Polychloropren, sulfuriertem Polyethylen, Ethylen-Acrylat-Kautschuk, Ethylen-Vinylactetat-Kautschuk, Epichlorhydrin-Copolymeren. Ethylen-Propylen-Copolymeren (EP(D)M), schwefelvernetzt oder peroxid-vernetzt, Polyether-Urethan-Kautschuk, Ethylen-Vinylacetat-Copolymer, Fluor-Kautschuk (FKM), Silikonkautschuken, insbesondere Fluorsilikon-Kautschuken, vinyl-haltigem Dimethylpolysiloxan, sowie hydriertem NitrilKautschuk, Butyl-Kautschuk, Halobutyl-Kautschuk, Polyoctenamer, Polypentenamer, Nitril-Kautschuk, Naturkautschuk, Thioplasten, Potyfiuorphosphazenen, Polynorbomenen, Styrol-Butadien-Kautschuken, carboxygruppen-haltigen Nitril-Kautschuken oder Gemischen aus einem oder mehreren dieser Kautschuke.

5. Magnetostriktives Element nach Anspruch 1, **dadurch gekennzeichnet, daß** das poröse Polymer sich ableitet von thermoplastischen Elastomeren, vorzugsweise von thermoplastischen Polyestern (TPE-E), thermoplastischen Polyamiden (TPE-A), unvernetzten thermoplastischen Polyolefinen (TPE-O), teilvernetzten thenmoplastischen Polyolefinen (TPE-V), thermoplastischen Styrolpolymeren (TPE-S) und insbesondere von thermoplastischen Polyurethanen (TPE-U).

6. Magnetostriktives Element nach Anspruch 1, **dadurch gekennzeichnet, daß** die ferromagnetischen Teilchen Eisen, Cobalt und/oder Nickel enthalten, und insbesondere ein weichmagnetisches Material sind,

7. Magnetostriktives Element nach Anspruch 1, **dadurch gekennzeichnet, daß** die ferromagnetischen Teilchen Cobalt-, Nickel- oder insbesondere Eisenpulver sind.

8. Magnetastriktives Element nach Anspruch 6, **dadurch gekennzeichnet, daß** das ferromagnetische Material neben Eisen und/oder Cobalt und/oder Nickel zusätzlich Mangan, Kupfer, Seltenerdmetalle oder Kombinationen von einem oder mehreren dieser Metalle enthält.

9. Magnetostriktives Element nach Anspruch 8, **dadurch gekennzeichnet, daß** das ferromagnetische Material Legierungen enthaltend Eisen und Seltenerdmetalle, insbesondere Legierungen enthaltend Terbium, Dysprosium und Eisen, aufweist.

10. Magnetostriktives Element nach Anspruch 1, **dadurch gekennzeichnet, daß** die ferromagnetischen Teilchen einen mittleren Durchmesser (D₅₀) von 0,1 Mikrometer bis 1 mm besitzen.

11. Verwendung eines magnetostriktiven Elements nach einem der vorgenannten Ansprüche zum Dämpfen von Schwingungen eines Gegenstandes durch die Maßnahmen:
i) Ermitteln des Schwingungsspektrums des Gegenstandes durch mindestens einen Sensor,
ii) Erzeugen eines zeitlich sich ändernden magnetischen Feldes, dessen zeitlicher Verlauf geeignet ist, zumindest einen Teil des Schwingungsspektrums des Gegenstandes durch Interferenz zu kompensieren,
iii) Einwirken des magnetischen Feldes auf mindestens ein Formteil nach Anspruch 1 und Erzeugen einer zeitlichen Änderung der Dimensionen dieses Formteils, und
iv) Einwirken des Formteils auf den Gegenstand, so daß dadurch dessen Schwingungen wenigstens teilweise kompensiert werden.

12. Verwendung eines magnetostriktiven Elements nach einem der Ansprüche 1 bis 10 zum Dämpfen von Schwingungen eines Gegenstandes durch die Maßnahmen:
xii) Erzeugen eines magnetischen Feldes vorbestimmter Größe in einer Vorrichtung nach Anspruch 1, das
xiii) auf mindestens ein Formteil nach Anspruch 1 einwirkt und dadurch die Dämpfungseigenschaften dieses Formteils in vorbestimmter Weise beeinflusst.

13. Verwendung eines magnetostriktiven Elements nach einem der Ansprüche 1 bis 10 zur Ermittlung der Änderung der Dimensionen eines Gegenstandes durch die Maßnahmen:
xiv) Einwirken des Gegenstands auf ein Formteil nach Anspruch 1, so daß sich bei Änderungen der Dimension des Gegenstands mindestens eine Dimension des Formteils verändert, und
xv) Ermitteln der Stärke des durch die Dimensionsänderung des Formteils erzeugten Magnetfeldes durch Induktion eines elektrischen Stroms in einem elektrischen Leiter, der sich in der Nähe des Formteils befindet.

14. Verwendung eines magnetostriktiven Elements nach einem der Ansprüche 1 bis 10 zur gezielten Veränderung der Position eines Gegenstandes durch die Maßnahmen:
xvi) Erzeugen eines magnetischen Feldes vorbestimmter Größe in einer Vorrichtung nach Anspruch 1, das
xvü) auf mindestens ein Formteil nach Anspruch 1, einwirkt und dadurch die Dimensionen des Formteils in vorbestimmter Weise beeinflußt, und
xviii) Einwirken des Formteils auf den Gegenstand, so daß dieser dadurch in vorbestimmter Weise bewegt wird.

15. Verwendung eines Formteils nach Anspruch 1 als Aktuator.

16. Verwendung eines Formteils nach Anspruch 1 als Dämpfungselement.

17. Verwendung eines Formteils nach Anspruch 1 als Sensor für mechanische Änderungen von Gegenständen, insbesondere als Schwingungssensor.

## Claims

1. Magnetostrictive element comprising
a) at least one device for generating a magnetic field and
b) at least one shaped part composed of porous polymer comprising ferromagnetic particles and gas-filled pores.

2. Magnetostrictive element according to Claim 1, **characterized in that** the shaped part composed of porous polymer is configured in the form of a cylinder around which the device for generating a magnetic field is wound in the form of a coil of electrically conductive material.

3. Magne-costrictive element according to Claim 1, **characterized in that** the porous polymer is an elastomer foam.

4. Magnetostrictive element according to Claim 3, **characterized in that** the elastomer foam derives from acrylate rubber, polyesterurethane rubber, brominated butyl rubber, polybutadiene, chlorinated butyl rubber, chlorinated polyethylene, epichlorohydrin homopolymer, polychloroprene, sulphonated polyethylene, ethylene-acrylate rubber, ethylene-vinyl acetate rubber, epichlorohydrin copolymers, ethylene-propylene copolymers (EP(D)M), sulphur-crosslinked or peroxide-crosslinked, polyetherurethane rubber, ethylene-vinyl acetate copolymer, fluoro rubber (FCR), silicone rubbers, especially fluorosilicone rubbers, vinyl-containing dimethylpolysiloxane, and also hydrogenated nitrile rubber, butyl rubber, halobutyl rubber, polyoctenamer, polypentenamer, nitrile rubber, natural rubber, thioplastics, polyfluorophosphazenes, polynorbornenes, styrene-butadiene rubbers, carboxyl-containing nitrile rubbers or mixtures of one or more of these rubbers.

5. Magnetostrictive element according to Claim 1, **characterized in that** the porous polymer derives from thermoplastic elastomers, preferably from thermoplastic polyesters (TPE-E), thermoplastic polyamides (TPE-A), uncrosslinked thermoplastic polyolefins (TPE-O), partly crosslinked thermoplastic polyolefins (TPE-V), thermoplastic styrene polymers (TPE-S) and especially from thermoplastic polyurethanes (TPE-U).

6. Magnetostrictive element according to Claim 1, **characterized in that** the ferromagnetic particles comprise iron, cobalt and/or nickel, and especially a soft-magnetic material.

7. Magnetostrictive element according to Claim 1, **characterized in that** the ferromagnetic particles are cobalt, nickel or especially iron powder.

8. Magnetostrictive element according to Claim 6, **characterized in that** the ferromagnetic material, as well as iron and/or cobalt and/or nickel, additionally comprises manganese, copper, rare earth metals or combinations of one or more of these metals.

9. Magnetostrictive element according to Claim 8, **characterized in that** the ferromagnetic material includes alloys comprising iron and rare earth metals, especially alloys comprising terbium, dysprosium and iron.

10. Magnetostrictive element according to Claim 1, **characterized in that** the ferromagnetic particles have a median diameter (D₅₀) of 0.1 micrometer to 1 mm.

11. Use of a magnetostrictive element according to any of the above claims for damping vibrations of an article by the measures of:
i) determining the vibration spectrum of the article by means of at least one sensor,
ii) generating a magnetic field which varies over time and has a profile against time suitable for compensating for at least part of the vibration spectrum of the article through interference,
iii) allowing the magnetic field to act on at least one shaped part according to Claim 1 and generating a change in the dimensions of this shaped part over time, and
iv) allowing the shaped part to act on the article, such that the vibrations thereof are at least compensated for thereby.

12. Use of a magnetostrictive element according to any of Claims 1 to 10 for damping vibrations of an article by the measures of:
xii) generating a magnetic field of predetermined size in a device according to Claim 1 which
xiii) acts on at least one shaped part according to Claim 1 and thus influences the damping properties of this shaped part in a predetermined manner.

13. Use of a magnetostrictive element according to any of Claims 1 to 10 for determining the change in the dimensions of an article by the measures of:
xiv) allowing the article to act on a shaped part according to Claim 1, such that changes in the dimensions of the article alter at least one dimension of the shaped part, and
xv) determining the strength of the magnetic field generated by the alteration in dimensions of the shaped part by inducing an electrical current in an electrical conductor in the vicinity of the shaped part.

14. Use of a magnetostrictive element according to any of Claims 1 to 10 for changing the position of an article in a controlled manner by the measures of:
xvi) generating a magnetic field of predetermined size in a device according to Claim 1 which
xvii) acts on at least one shaped part according to Claim 1 and thus influences the dimensions of the shaped part in a predetermined manner, and
xviii) allowing the shaped part to act on the article such that it is moved in a predetermined manner thereby.

15. Use of a shaped part according to Claim 1 as an actuator.

16. Use of a shaped part according to Claim 1 as a damping element.

17. Use of a shaped part according to Claim 1 as a sensor for mechanical changes in articles, especially as a vibration sensor.

## Revendications

1. Elément magnétostrictif comprenant
a) au moins un dispositif de génération d'un champ magnétique et
b) au moins une pièce moulée en polymère poreux contenant des particules ferromagnétiques et ayant des pores remplis de gaz.

2. Elément magnétostrictif selon la revendication 1, **caractérisé en ce que** la pièce moulée en polymère poreux est réalisée sous la forme d'un cylindre afin d'enrouler le dispositif de génération d'un champ magnétique en forme de bobine en matériau électriquement conducteur.

3. Elément magnétostrictif selon la revendication 1, **caractérisé en ce que** le polymère poreux est une mousse d'élastomère.

4. Elément magnétostrictif selon la revendication 3, **caractérisé en ce que** la mousse d'élastomère dérive de caoutchouc acrylate, caoutchouc polyester-uréthane, butyle caoutchouc bromé, polybutadiène, butyle caoutchouc chloré, polyéthylène chloré, épichlorhydrine homopolymère, polychloroprène, polyéthylène sulfuré, caoutchouc éthylène-acrylate, caoutchouc éthylène-vinylacétate, épichlorhydrine copolymères, éthylène-propylène copolymères (EP(D)M), réticulés au soufre ou au peroxyde, caoutchouc polyéther-uréthane, éthylène-vinylacétate copolymère, caoutchouc fluor (CF), caoutchoucs silicone, en particulier caoutchoucs fluorosilicone, diméthylpolysiloxane contenant du vinyle, de même que caoutchouc nitrile hydraté, caoutchouc butyle, caoutchouc halobutyle, polyocténamère, polypentènamère, caoutchouc nitrile, caoutchouc naturel, thioplastes, polyfluorophosphazènes, polynorbornènes, caoutchoucs styrène-butadiène, caoutchoucs nitriles contenant des groupes carboxy ou des mélanges d'un ou plusieurs de ces caoutchoucs.

5. Elément magnétostrictif selon la revendication 1, **caractérisé en ce que** le polymère poreux dérive d'élastomères thermoplastiques, de préférence polyesters thermoplastiques (TPE-E), polyamides thermoplastiques (TPE-A), polyoléfines thermoplastiques non réticulées (TPE-O), polyoléfines thermoplastiques partiellement réticulées (TPE-V), styrène polymères thermoplastiques (TPE-S) et en particulier de polyuréthanes thermoplastiques (TPE-U).

6. Elément magnétostrictif selon la revendication 1, **caractérisé en ce que** les particules ferromagnétiques contiennent du fer, du cobalt et/ou du nickel et en particulier sont un matériau magnétique doux.

7. Elément magnètostrictif selon la revendication 1, **caractérisé en ce que** les particules ferromagnétiques sont des particules de poudre de cobalt, de nickel ou en particulier de fer.

8. Elément magnétostrictif selon la revendication 6, **caractérisé en ce que** le matériau ferromagnétique contient, outre du fer et/ou du cobalt et/ou du nickel, en plus du manganèse, du cuivre, des métaux terreux collatéraux ou des combinaisons d'un ou plusieurs de ces métaux.

9. Elément magnétostrictif selon la revendication 8, **caractérisé en ce que** le matériau ferromagnétique présente des alliages contenant du fer et des métaux terreux collatéraux, en particulier des alliages contenant du terbium, du dysprosium et du fer.

10. Elément magnétostrictif selon la revendication 1, **caractérisé en ce que** les particules ferromagnétiques ont un diamètre moyen (D₅₀) de 0,1 micromètre à 1 mm.

11. Utilisation d'un élément magnétostrictif selon une des revendications précédentes pour amortir des vibrations d'un objet par les mesures consistant à :
i) déterminer le spectre de vibration de l'objet à l'aide d'au moins un capteur,
ii) générer un champ magnétique variant dans le temps dont l'évolution chronologique est apte à compenser au moins une partie du spectre de vibration de l'objet par interférence,
iii) faire agir le champ magnétique sur au moins une pièce moulée selon la revendication 1 et générer une modification chronologique des dimensions de cette pièce moulée et
iv) faire agir la pièce moulée sur l'objet de manière à compenser ainsi au moins partiellement ses vibrations.

12. Utilisation d'un élément magnétostrictif selon une des revendications 1 à 10 pour amortir des vibrations d'un objet par les mesures consistant à :
xii) générer un champ magnétique d'une taille prédéfinie dans un dispositif selon la revendication 1, qui
xiii) agit sur au moins une pièce moulée selon la revendication 1 et influe ainsi sur les propriétés d'amortissement de cette pièce moulée d'une manière prédéfinie.

13. Utilisation d'un élément magnétostrictif selon une des revendications 1 à 10 pour déterminer la modification des dimensions d'un objet par les mesures consistant à :
xiv) faire agir l'objet sur une pièce moulée selon la revendication 1 de manière à modifier, en cas de modifications de la dimension de l'objet, au moins une dimension de la pièce moulée et
xv) déterminer l'épaisseur du champ magnétique généré par le changement de dimension de la pièce moulée par induction d'un courant électrique dans un conducteur électrique qui se trouve à proximité de la pièce moulée.

14. Utilisation d'un élément magnétostrictif selon une des revendications 1 à 10 pour modifier délibérément la position d'un objet par les mesures consistant à :
xvi) générer un champ magnétique d'une taille prédéfinie dans un dispositif selon la revendication 1, qui
xvii) agit sur au moins une pièce moulée selon la revendication 1 et influe ainsi sur les dimensions de la pièce moulée d'une manière prédéfinie et xviii) faire agir la pièce moulée sur l'objet de manière à déplacer ainsi celui-ci d'une manière prédéfinie.

15. Utilisation d'une pièce moulée selon la revendication 1 comme actionneur.

16. Utilisation d'une pièce moulée selon la revendication 1 comme élément amortisseur.

17. Utilisation d'une pièce moulée selon la revendication 1 comme capteur pour modifier mécaniquement des objets, en particulier comme capteur de vibration.
